# FASCICULE DE BREVET EUROPEEN

(11) **EP 3 378 098 B1**
(45) Date de publication et mention de la délivrance du brevet: **04.12.2019**
(21) Numéro de dépôt: 16812998.9
(22) Date de dépôt: 17.11.2016
(51) Int. Cl.: H01L 29/872, H01L 29/861, H01L 21/329, H01L 29/205, H01L 29/40

(54) **DIODE A HETEROJONCTION AYANT UN COURANT DE SURCHARGE TRANSITOIRE ACCRU**
HETEROÜBERGANGDIODE MIT ERHÖHTEM TRANSIENTEM SPITZENSTROM
HETEROJUNCTION DIODE HAVING AN INCREASED TRANSIENT SURGE CURRENT

(30) Priorité: 17.11.2015 FR 1561049
(43) Date de publication de la demande: 26.09.2018
(73) Titulaire: Commissariat à l'Énergie Atomique et aux Énergies Alternatives, 75015 Paris (FR)
(72) Inventeur: BAINES, Yannick, 38000 Grenoble (FR); BUCKLEY, Julien, 38000 Grenoble (FR)
(74) Mandataire: GIE Innovation Competence Group
(86) Numéro de dépôt international: PCT/FR2016/052997
(87) Numéro de publication internationale: WO 2017/085413

(56) Documents cités:
- JP-A- 2012 028 409
- JP-A- 2015 198 175
- US-A1- 2013 105 815
- US-A1- 2015 069 410

## Description

L'invention concerne les diodes à hétérojonction, et en particulier les diodes de puissance devant supporter un courant de surcharge transitoire fortement accru.

Les diodes à hétérojonction de type III-N sont utilisées de façon croissante pour des applications de puissance, pour répondre à des contraintes importantes en termes de consommation électrique, de tensions et de courants d'utilisation.

Le brevet US2014231873 décrit une diode à hétérojonction. Cette diode à hétérojonction comprend une superposition d'une couche de GaN et d'une couche d'AlGaN. Une couche de gaz d'électrons est formée à l'interface entre la couche d'AlGaN et la couche de GaN, du fait d'une polarisation spontanée et d'une polarisation piézoélectrique. La couche de gaz d'électrons fait office de canal de la diode et permet une très grande densité de courant avec une résistance de conduction très basse. Une telle diode présente en outre une tension de seuil très basse, permettant de réduire la consommation électrique lorsqu'elle est polarisée en direct.

Un contact Schottky est formé sur la couche d'AlGaN pour former une anode. Un contact ohmique est formé à travers la couche d'AlgaN et est en contact à la fois avec la couche d'AlGaN et la couche de GaN, pour former une cathode. Une couche de passivation en SiN est formée sur la couche d'AlGaN entre l'anode et la cathode. Une couche de GaN dopée P est formée sur la couche d'AlGaN. Elle est mise en forme pour être délimitée latéralement par l'anode et la couche de passivation, et elle est recouverte par l'anode et la couche de passivation. Cette couche de GaN est destinée à réduire les courants de fuite entre l'anode et la cathode à l'état bloqué, de tels courants de fuite pouvant apparaître à l'interface entre la couche de passivation et la couche d'AlGaN.

Les diodes de puissance doivent notamment répondre à une spécification de courant de surcharge non répétitive sans dégradation de performance, désignée par l'acronyme Ifsm. Cette valeur doit de préférence être d'environ dix fois le calibre du courant direct de la diode. La couche de gaz d'électrons possède des limitations en termes de courant maximal supporté, limitant l'amplitude du courant Ifsm par rapport au calibre.

Il existe donc un besoin pour une diode de puissance présentant un courant de surcharge Ifsm relativement élevé par rapport à son calibre et dont la structure soit relativement aisée à réaliser.

En référence à sa figure 7, le document JP2015 198175 décrit une diode à hétérojonction, comprenant :
- une première couche semiconductrice 31 en GaN ;
- une deuxième couche semiconductrice 14 en AlGaN superposée sur la première pour former un gaz d'électron A ;
- une anode 35A et une cathode 35C sélectivement connectées l'une à l'autre par l'intermédiaire de la couche de gaz d'électrons ;
- une troisième couche semiconductrice 31 positionnée sous la couche de gaz d'électrons et sous la première couche semi-conductrice 31 ;
- un premier élément semi-conducteur 33 à dopage de type P, en contact avec l'anode 35A ;
- un deuxième élément semi-conducteur 34 à dopage de type N, en contact avec la cathode 35C et formant une séparation entre la cathode 35C et la troisième couche 31 ;
- le premier élément semi-conducteur 33, la troisième couche semi-conductrice 31, le deuxième élément semi-conducteur 34 et une partie de la première couche semi-conductrice 32 interposée entre le premier élément semi-conducteur 33 et la troisième couche semi-conductrice 31 formant une diode PIN.

Une telle diode présente des inconvénients. En vue d'augmenter le courant à l'état passant, le document utilise une concentration élevée de dopants dans la troisième couche semi-conductrice 31, au détriment de la résistance de claquage en tension entre l'anode et la cathode. Pour des tensions élevées, cela impose en pratique une épaisseur importante de la partie de la première couche semi-conductrice 32 interposée entre l'élément semi-conducteur 33 et la couche semi-conductrice 31.

Le document JP2012 028409 décrit :
- une diode à hétérojonction, comprenant :
- une première couche en GaN ;
- une deuxième couche en AlGaN superposée sur la première pour former un gaz d'électron ;
- une anode et une cathode sélectivement connectées l'une à l'autre par l'intermédiaire de la couche de gaz d'électrons ;
- un premier élément semi-conducteur à dopage de type P, en contact avec l'anode ;
- un deuxième élément semi-conducteur à dopage de type N en contact avec la cathode ;
- une diode PIN sous-jacente formée avec les éléments semi-conducteurs.

L'invention vise à résoudre un ou plusieurs de ces inconvénients. L'invention porte ainsi sur une diode à hétérojonction, telle que définie dans la revendication 1 annexée.

L'invention porte également sur les variantes définies dans les revendications dépendantes annexées. L'homme du métier comprendra que chacune des caractéristiques de ces variantes peut être combinée indépendamment aux caractéristiques de la revendication 1, sans pour autant constituer une généralisation intermédiaire.

L'invention porte également sur un procédé de fabrication d'une diode à hétérojonction, tel que défini dans la revendication 13 annexée.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe schématique d'un exemple de structure de diode à heterojonction selon un premier mode de réalisation de l'invention ;
- la figure 2 est une vue en coupe schématique d'un exemple de structure de diode à heterojonction selon un deuxième mode de réalisation de l'invention ;
- la figure 3 est un schéma électrique équivalent à une structure de diode selon l'invention ;
- les figures 4 à 13 sont des vues en coupe de différentes étapes d'un procédé de fabrication d'une structure de diode selon le premier mode de réalisation ;
- la figure 14 est une vue en coupe d'une variante de structure de diode selon le premier mode de réalisation ;
- les figures 15 et 16 sont des vues en coupe de variantes d'étapes d'un procédé de fabrication ;
- les figures 17 à 21 sont des vues en coupe de différentes étapes d'une variante d'un procédé de fabrication d'une structure de diode.

L'invention propose de former une diode PIN sous une diode à heterojonction, entre l'anode et la cathode de cette diode à heterojonction. La structure ainsi obtenue permet à la fois de bénéficier d'une forte densité de courant de la diode à heterojonction à l'état passant, et de permettre une conduction additionnelle par la diode PIN en cas de surcharge transitoire.

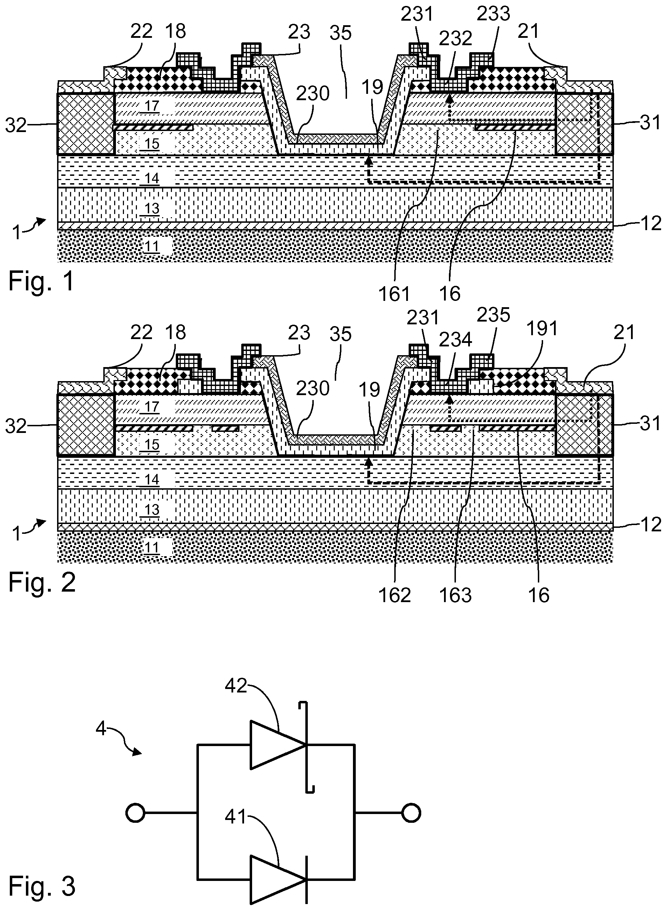

La figure 1 est une vue en coupe d'un circuit intégré incluant une structure de diode 1 selon un exemple d'un premier mode de réalisation de l'invention. Dans l'exemple illustré, deux diodes à heterojonction sont formées avec une anode commune. La structure de diode 1 comporte :
- un substrat 11. Le substrat 11 peut être un isolant ou un semiconducteur de type silicium intrinsèque ou dopé. Le substrat 11 pourra par exemple être de type silicium à orientation de maille (111). Le substrat 11 peut également être notamment du carbure de silicium, ou du saphir. Le substrat 11 peut présenter une épaisseur de l'ordre de 650 µm, typiquement comprise entre 400 µm et 2mm ;
- éventuellement une couche d'adaptation 12 disposée sur le substrat 11. La couche d'adaptation 12, déposée de façon connue en soi sur le substrat 11, sert d'intermédiaire entre ce substrat et la couche semi conductrice 13 détaillée par la suite, ou une autre couche semi-conductrice en l'absence de couche 13. La couche d'adaptation 12 permet une adaptation de maille entre le substrat 11 et cette couche semi conductrice 13. La couche d'adaptation 12 peut typiquement être en nitrure d'aluminium pour une couche semi conductrice 13 en GaN ;
- éventuellement une couche tampon semi-conductrice 13 (par exemple de type III-V, par exemple en nitrure d'élément III, typiquement du GaN non intentionnellement dopé), ici disposée sur la couche d'adaptation 12. Un semi-conducteur non intentionnellement dopé désigne usuellement un semi-conducteur dans lequel des impuretés n'ont pas été introduites intentionnellement. Un tel semi-conducteur présente typiquement une concentration en impuretés au plus égale à 10¹⁵cm⁻³. On peut également utiliser du GaN dopé incluant de fortes concentration en Carbone (par exemple supérieure à 10¹⁸cm⁻³ en vue d'accroître les propriétés d'isolation électrique de cette couche);
- une couche semi-conductrice 14 (en GaN, cas particulier de matériau de type III-N), présentant un dopage réduit. La couche 14 est ici formée sur la couche tampon semi conductrice 13. La couche 14 présente un dopage de type N avec une concentration au plus égale à 4^{∗}10¹⁶cm⁻³, cette concentration étant avantageusement au moins égale à 5^{∗}10¹⁵cm⁻³. La couche semi conductrice 14 présente typiquement une épaisseur d'au moins 100 nm, de préférence au moins 150nm ;
- une couche semi conductrice 15 en GaN non intentionnellement dopé. La couche semi conductrice 15 est ici formée sur la couche semi conductrice 14. La couche semi conductrice 15 présente typiquement une épaisseur de 100 nm ;
- une couche semi conductrice 17 en matériau III-N (par exemple un alliage ternaire de type III-N, par exemple du AlGaN, en particulier du AlGaN présentant une fraction molaire d'aluminium comprise entre 20 et 30 %). La couche semi conductrice 17 est ici formée sur la couche semi conductrice 15. La couche semi-conductrice comprend une bande interdite plus élevée que celle de la couche semi-conductrice 15 par exemple de l'AlGaN, de l'InAlN ou de l'AlN). La couche semi conductrice 17 présente typiquement une épaisseur de 25 nm, par exemple comprise entre 10 et 40 nm. Les couches semi conductrices 15 et 17 sont superposées de façon connue en soi pour former une couche de gaz d'électrons 16 à l'interface ou à proximité de l'interface entre ces couches 15 et 17. La couche de gaz d'électrons 16 est ainsi formée au-dessus de la couche semi conductrice 14;
- un élément semi-conducteur 19 (par exemple un alliage de type III-N, par exemple du GaN, ou par exemple de l'AlGaN, ou du polysilicium) à dopage de type P. La concentration de dopants P dans cet élément semi-conducteur 19 est avantageusement comprise entre 5^{∗}10¹⁷cm⁻³ et 10²⁰cm⁻³. Les concentrations les plus élevées de dopant P pourront en particulier être obtenues pour un élément semi-conducteur 19 en Polysilicium. L'élément semi-conducteur 19 est en contact avec la couche 14;
- des éléments semi-conducteurs 31 et 32 disposés de part et d'autre de l'élément semi-conducteur 19, à distance de cet élément semi-conducteur 19. Les éléments semi-conducteurs 31 et 32 présentent un dopage de type N. La concentration de dopants de type N des éléments semi-conducteurs 31 et 32 est avantageusement comprise entre 5^{∗}10¹⁷cm⁻³ et 10²⁰cm⁻³. Les éléments semi-conducteurs 31 et 32 sont en contact avec la couche 14. Les éléments semi-conducteurs 31 et 32 sont formés par exemple par une implantation de dopant N dans les couches 15 et 17, par exemple du Silicium. Les éléments 31 et 32 peuvent également être réalisés en Polysilicium dopé N. Les concentrations les plus élevées de dopant N pourront en particulier être obtenues pour des éléments semi-conducteur 31 et 32 en Polysilicium.;
- une anode métallique 23, en contact avec l'élément semi-conducteur 19. L'élément semi-conducteur 19 forme une séparation entre la couche 14 et l'anode 23. Dans l'exemple, l'anode métallique 23 recouvre l'élément semi-conducteur 19. L'anode métallique 23 comporte une partie centrale 230 recouvrant l'élément semi-conducteur 19. L'anode 23 présente une partie saillante latéralement 231. La partie 231 est saillante par rapport à l'élément semi-conducteur 19 en direction de la cathode 21. La partie saillante 231 traverse la couche de passivation 18 et forme un contact Schottky 232 avec la couche 17. La partie saillante 231 présente un prolongement 233 vers l'anode 21, au-delà du contact Schottky 232, surplombant la couche de passivation 18.

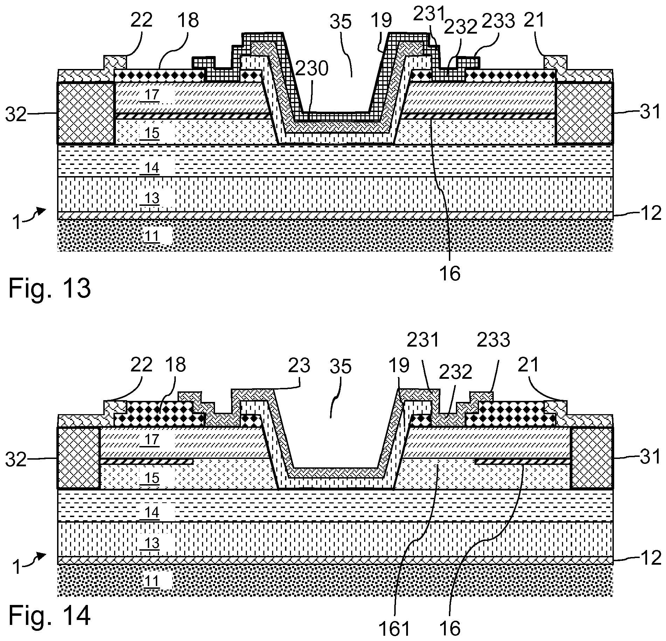

La partie centrale 230 et la partie saillante 231 de l'anode 23 peuvent être réalisées dans deux matériaux différents. La partie 231 est configurée pour former un contact Schottky avec la couche 17, la partie centrale formant de préférence un contact ohmique à l'interface avec l'élément semi-conducteur 19. Les matériaux pour la partie centrale 230 et/ou la partie saillante 231 sont par exemple choisis parmi le Nickel, le palladium, l'or, le TiN, le Platine ou une superposition de couches d'au moins deux de ces matériaux. Si un travail de sortie élevé est recherché pour une partie de l'anode 23, le Nickel est un choix permettant d'obtenir un bon compromis entre son coût et le niveau du travail de sortie qu'il permet d'obtenir. Pour un élément semi-conducteur 19 en GaN dopé P, on recherche par exemple une partie centrale 230 de l'anode 23 ayant un travail de sortie élevé. Pour un élément semi-conducteur 19 en Polysilicium dopé P, on peut utiliser une partie centrale 230 de l'anode 23 ayant un travail de sortie plus réduit, obtenue par exemple par Siliciuration et dépôt de TiN ;
- des cathodes métalliques 21 et 22, en contact respectivement avec les éléments semi-conducteurs 31 et 32. Les cathodes métalliques 21 et 22 forment des contacts ohmiques avec les éléments semi-conducteurs 31 et 32 respectivement. Les éléments semi-conducteurs 31 et 32 forment une séparation entre la couche 14 et les cathodes 21 et 22 respectivement. Les cathodes 21 et 22 sont disposées de part et d'autre de l'anode 23, à distance de cette anode 23. Les cathodes 21 et 22 sont destinées de façon connue en soi à être sélectivement connectées à l'anode 23 par l'intermédiaire de la couche de gaz d'électrons 16, en fonction des potentiels qui leur sont appliqués. Les cathodes métalliques 21 et 22 peuvent être formées de façon connue en soi de films multicouches d'aluminium et de titane, d'aluminium et de tantale. Dans l'exemple illustré à la figure 14 (applicable à tous les modes de réalisation), les cathodes métalliques 21 et 22 forment un débordement sur la couche 17 ;
- avantageusement, une couche de passivation 18 (par exemple en nitrure de Silicium, en SiO₂ ou en Al₂O₃). Cette couche de passivation 18 présente typiquement une épaisseur d'au moins 100nm, réalisée avec une ou plusieurs couches superposées. La couche de passivation 18 est formée sur la couche semi-conductrice 17. La couche de passivation 18 forme une protection de la couche 17, et une isolation électrique entre l'anode 23 et les cathodes 21 et 22.

Des circuits non illustrés appliquent sélectivement des polarisations électriques sur les cathodes 21, 22 et sur l'anode 23. Les dimensions des différents éléments et couches sont uniquement illustrés schématiquement, leurs dimensions et structures pouvant différer fortement de l'illustration de la figure 1.

La structure de diode 1 de la figure 1 forme un circuit 4 schématisé à la figure 3, d'une part entre l'anode 23 et la cathode 21, et d'autre part entre l'anode 23 et la cathode 22. Le circuit 4 comporte d'une part une diode Schottky 41 à hétérojonction et d'autre part une diode PIN 42, connectées en parallèle (anodes et cathodes communes).

Une diode à hétérojonction 41 est formée entre l'anode 23 et la cathode 21. En l'absence de polarisation sur l'anode 23 et sur la cathode 21, la diode 41 formée est à l'état bloqué. En effet, l'élément semi-conducteur 19 dopé P et le contact Schottky 232 génèrent une zone 161 déplétée à l'interface entre les couches 15 et 17, à proximité de l'élément 19 et à l'aplomb du contact Schottky 232. La couche de gaz d'électrons 16 est donc interrompue avant d'atteindre l'aplomb du contact Schottky 232. Une diode à hétérojonction bloquée est ainsi formée entre le contact Schottky 232 et la cathode 21, à travers l'élément 31, la couche de gaz d'électrons 16 et les couches 15 et 17. Avec l'application d'une différence de potentiel entre la cathode 21 et l'anode 23 supérieure à sa tension de seuil, la couche de gaz d'électrons 16 est reconstituée à l'aplomb du contact Schottky 232. La diode 41 formée est alors passante, avec une conduction électrique à travers l'élément 31, la couche de gaz d'électrons 16 et la couche 17, comme illustré par la flèche en pointillés représentant schématiquement le courant à l'état passant. L'état passant de la diode à hétérojonction 41 est obtenu de façon connue en soi avec une différence de potentiel relativement réduite entre l'anode 23 et la cathode 21 (par exemple une tension de seuil de l'ordre de 0,5 V), permettant de limiter la chute de potentiel et les pertes dans cette diode 41 à l'état passant.

Une diode PIN 42 est formée entre l'anode 23 et la cathode 21. La zone dopée P de la diode PIN 42 est formée par l'élément 19. La zone dopée N de la diode PIN 42 est formée par l'élément 31. La zone appelée intrinsèque de la diode PIN 42 est formée par la couche 14 (faiblement dopée n) intercalée entre les éléments 19 et 31. Avec l'application d'une différence de potentiel appropriée entre la cathode 21 et l'anode 23, cette diode 42 est rendue passante. La diode PIN 42 assure alors une conduction électrique par l'intermédiaire de l'élément 19, de la couche 14, et de l'élément 31, comme illustré par le courant d'électrons représenté par la flèche en trait discontinu à la figure 1. Une diode PIN étant dans l'idéal bipolaire, il existe aussi un courant de trous dans le sens opposé. La différence de potentiel à appliquer entre la cathode 21 et l'anode 23 est supérieure à la tension de seuil de la diode à hétérojonction 41. Ainsi, lors d'une surcharge transitoire de courant, la diode PIN 42 formée fournit un second canal de conduction physiquement séparé de celui de la diode à hétérojonction 41. La structure de diode 1 ainsi formée permet par conséquent d'obtenir un courant de surcharge transitoire nettement supérieur au courant nominal de la diode à hétérojonction 41.

Comme détaillé précédemment, la couche 14 en GaN présente une concentration de dopants au plus égale à 4^{∗}10¹⁶cm⁻³. Une telle concentration de dopants permet d'éviter un claquage de cette couche 14 presque indépendamment de sa longueur (longueur anode-cathode), pour des différences de potentiel entre l'anode et la cathode de plusieurs centaines de Volts, typiquement jusqu'à 2000V. La concentration de dopants dans la couche 14 est inférieure à la concentration de dopants dans l'élément semi-conducteur 19, et à la concentration de dopants dans les éléments semi-conducteurs 31 ou 32. La couche 14 présente avantageusement une concentration de dopants au moins égale à 5^{∗}10¹⁵ cm⁻³ en particulier si cette couche 14 est en GaN Une telle concentration de dopants permet de favoriser la conduction électrique dans la diode PIN 42 lorsque celle-ci est passante.

Dans l'exemple illustré à la figure 1, une tranchée 35 est ménagée à travers les couches 15 et 17. Le fonds de la tranchée 35 est délimité par la couche 14, les parois latérales et le fond de la tranchée 35 étant recouverts par l'élément semi-conducteur 19, de sorte que l'élément semi-conducteur 19 est en contact avec la couche 14 dans le fond de la tranchée 35. Le fond de l'élément 19 est destiné à former la zone dopée P de la diode PIN 42. Les flancs (optionnels) de l'élément 19 en contact avec les parois de la tranchée 35 sont ici avantageusement ménagés pour dépléter une partie de l'interface entre les couches 15 et 17. La hauteur des flancs de l'élément 19 est ici au moins égale à la somme des épaisseurs des couches 15, 17 et 18 (typiquement supérieure à 200 nm).

La largeur de l'élément semi-conducteur 19 est dimensionnée en fonction du courant de surcharge transitoire que l'on souhaite conduire à travers la diode PIN 42 rendue passante. Cette largeur pourra typiquement être comprise entre 1 et 5 µm pour une structure de diode 1 de puissance. La largeur de l'élément semi-conducteur 19 sera avantageusement limitée, afin de conserver une largeur suffisante pour une partie saillante 231, cette partie saillante étant destinée à conduire le courant de la diode à heterojonction 41 passante, dans un fonctionnement normal.

L'anode 23 comporte ici un prolongement 233 en direction de la cathode 21, au-delà du contact Schottky 232. Ce prolongement 233 surplombe la couche de passivation 18 et permet d'accroître la portée du champ électrique appliqué par l'anode 23 au niveau de l'interface entre les couches 15 et 17, lorsque la diode 41 est polarisée à l'état passant. Afin de réduire les risques de claquage de la couche de passivation 18, la couche 18 présente avantageusement une épaisseur croissante sous le prolongement 233, en direction de la cathode 21. Le prolongement 233 et la couche 18 sous-jacente présentent ici une forme d'escalier en direction de la cathode 21. Une telle configuration permet de limiter les risques de claquage de la couche 18 pour des tensions élevées.

Le contact Schottky 232 présente une largeur dimensionnée de façon connue en soi pour permettre le passage du courant nominal de la diode 41 à l'état passant.

La figure 2 est une vue en coupe d'une structure de diode 1 selon un exemple d'un deuxième mode de réalisation de l'invention. Comme pour la structure de la figure 1, deux diodes à heterojonction sont formées avec une anode commune.

La structure de diode 1 de la figure 2 comporte les éléments suivants, présentant une structure et une composition similaires à celles du premier mode de réalisation, et qui ne seront donc pas détaillées à nouveau :
- un substrat 11 ;
- une couche d'adaptation 12 ;
- une couche semi conductrice 13 ;
- une couche semi conductrice 14 ;
- une couche semi conductrice 15 ;
- une couche semi conductrice 17 ;
- une couche 16 de gaz d'électrons ;
- un élément semi-conducteur 19 ;
- des éléments semi-conducteurs 31 et 32 ;
- des cathodes 21 et 22 ;
- une tranchée 35 ménagée à travers les couches 15 et 17.

Dans le deuxième mode de réalisation, la structure de diode 1 comprend également une anode 23 en contact avec l'élément semi-conducteur 19. L'anode 23 recouvre également l'élément semi-conducteur 19. L'anode métallique 23 comporte une partie centrale 230 recouvrant l'élément semi-conducteur 19. L'anode 23 présente également une partie saillante latéralement 231. La partie 231 est saillante par rapport à l'élément semi-conducteur 19 en direction de la cathode 21. La partie saillante 231 traverse une couche de passivation 18. La partie saillante 231 forme un contact ohmique ou (de préférence) Schottky 234 traversant la couche de passivation pour former un contact avec la couche 17.

La partie centrale 230 et la partie saillante 231 de l'anode 23 peuvent être réalisées dans deux matériaux différents, comme illustré ici. Les matériaux pour la partie centrale 230 et/ou la partie saillante 231 sont par exemple choisis parmi l'Aluminium, le Titane, le Nickel, ou dans une superposition de couches de ces matériaux. Les critères de choix de matériaux des parties centrale et saillante d'anode 23 décrits précédemment sont également applicables à ce mode de réalisation. La partie saillante 231 présente un prolongement 235 vers l'anode 21, au-delà du contact ohmique 234. Le prolongement 235 surplombe un élément semi-conducteur 191 à dopage P, typiquement dans le même matériau que l'élément semi-conducteur 19. L'élément semi-conducteur 191 est ici positionné entre le contact ohmique 234 et la cathode 21. L'élément semi-conducteur 191 est en contact avec la couche 17.

Une diode à hétérojonction 41 (par référence à la figure 3) est ici également formée entre l'anode 23 et la cathode 21. En l'absence de polarisation sur l'anode 23 et sur la cathode 21, la diode 41 formée est à l'état bloqué. En effet, l'élément semi-conducteur 191 dopé P génère une zone 163 déplétée à l'interface entre les couches 15 et 17, à l'aplomb de cet élément 191. La couche de gaz d'électrons 16 est donc interrompue avant d'atteindre l'aplomb du contact ohmique 234. L'élément semi-conducteur 19 dopé P génère également une zone 162 déplétée à l'interface entre les couches 15 et 17. Une diode à hétérojonction bloquée est ainsi formée entre le contact 234 et la cathode 21, à travers l'élément 31, la couche de gaz d'électrons 16 et les couches 15 et 17. Avec l'application d'une différence de potentiel entre la cathode 21 et l'anode 23 supérieure à sa tension de seuil, la couche de gaz d'électrons 16 est reconstituée à l'aplomb de l'élément semi-conducteur 191. La diode 41 formée est alors passante, avec une conduction électrique à travers l'élément 31, la couche de gaz d'électrons 16 et la couche 17, comme illustré par la flèche en pointillés représentant schématiquement le courant à l'état passant. L'état passant de la diode à hétérojonction 41 est obtenu de façon connue en soi avec une différence de potentiel relativement réduite entre l'anode 23 et la cathode 21 (par exemple une tension de seuil de l'ordre de 0,5 V), permettant de limiter la chute de potentiel et les pertes dans cette diode 41 à l'état passant.

Une diode PIN 42 est formée entre l'anode 23 et la cathode 21 et présente une structure identique à celle détaillée en référence à la figure 1. La différence de potentiel à appliquer entre la cathode 21 et l'anode 23 est supérieure à la tension de seuil de la diode à heterojonction 41. Ainsi, comme pour le premier mode de réalisation, lors d'une surcharge transitoire de courant, la diode PIN 42 formée fournit un second canal de conduction physiquement séparé de celui de la diode à heterojonction 41. La structure de diode 1 ainsi formée permet par conséquent d'obtenir un courant de surcharge transitoire nettement supérieur au courant nominal de la diode à heterojonction 41.

Des circuits non illustrés appliquent sélectivement des polarisations électriques sur les cathodes 21, 22 et sur la cathode 23.

Le contact 234 présente une largeur dimensionnée de façon connue en soi pour permettre le passage du courant nominal de la diode 41 à l'état passant.

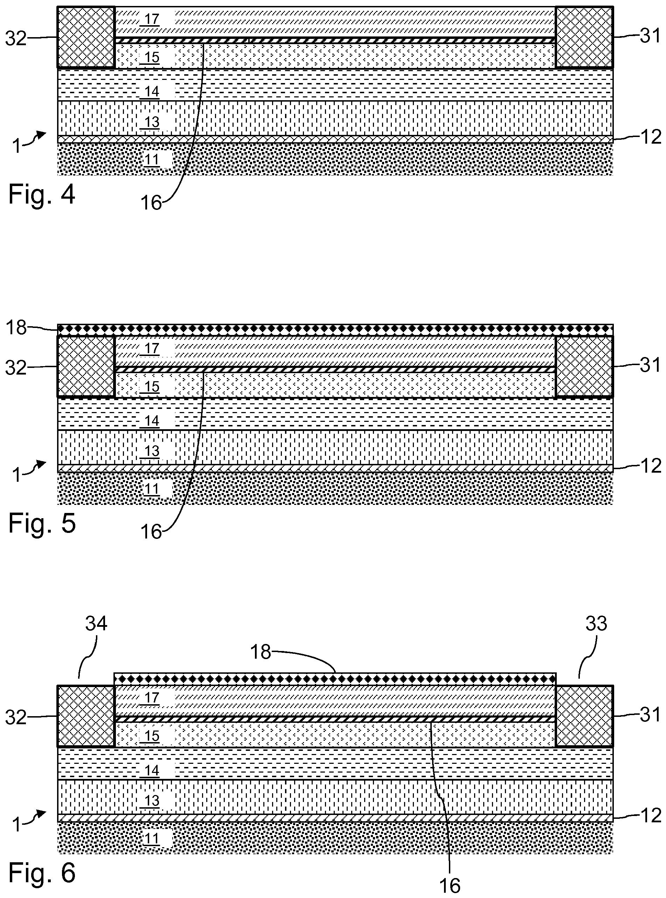

Les figures 4 à 13 sont des vues en coupe de différentes étapes d'un exemple de procédé de fabrication d'une structure de diode 1 selon le premier mode de réalisation.

À la figure 4, on fournit un wafer comportant un substrat 11, surmonté d'une couche d'adaptation 12, surmontée d'une couche tampon semi conductrice 13, surmontée d'une couche semi conductrice 14 présentant un dopage réduit en matériau III-N, surmontée d'une couche semi conductrice 15 en matériau III-N, surmontée d'une couche semi conductrice 17 en matériau III-N pour former de façon connue en soi une couche de gaz d'électrons 16 au niveau de l'interface entre ces couches 15 et 17. Les couches 11 à 17 peuvent présenter une composition et des dimensions telles que détaillées précédemment. Les éléments semi-conducteurs 31 et 32 sont ménagées à distance l'un de l'autre. Les éléments semi-conducteurs 31 et 32 s'étendent chacun en profondeur depuis la surface de la couche 17 jusqu'au contact de la couche 14. Les éléments semi-conducteurs 31 et 32 sont en contact latéralement avec les couches 15 et 17 et avec la couche de gaz d'électrons 16.

Les éléments semi-conducteurs 31 et 32 peuvent être réalisés par exemple par implantation de dopant N dans les couches 15 et 17, par exemple par implantation de silicium. L'implantation du silicium peut être suivie d'une étape de recuit d'activation des dopants, de façon connue en soi. Les éléments semi-conducteurs 31 et 32 peuvent également être réalisés par gravure puis dépôt d'une couche de polysilicium, avec un dopage de type N. Les éléments semi-conducteurs 31 et 32 peuvent également être réalisés suite à une étape de croissance par épitaxie d'un semi-conducteur dopé N sur la couche 14.

À la figure 5, on procède à la formation d'une couche de passivation 18 pleine plaque. Cette formation est par exemple réalisée par un dépôt pleine plaque d'une couche d'isolant tel que du SiN. L'étape de recuit d'activation citée précédemment sera avantageusement réalisée après la formation de la couche de passivation 18.

À la figure 6, on procède au retrait de la couche de passivation 18 à l'aplomb des éléments semi-conducteurs 31 et 32, de façon à ménager des zones dégagées 33 et 34 donnant accès aux faces supérieures des éléments semi-conducteurs 31 et 32 respectivement. Pour former des cathodes 21 et 22 débordant sur la couche 17 comme détaillé précédemment, le retrait de la couche de passivation 18 peut dépasser latéralement les éléments semi-conducteurs 31 et 32. Les zones 33 et 34 sont par exemple formées par des étapes de photolithographie, puis de gravure de la couche de passivation 18 pour dégager l'accès aux faces supérieures des éléments semi-conducteurs 31 et 32, puis de retrait du masque de photolithographie.

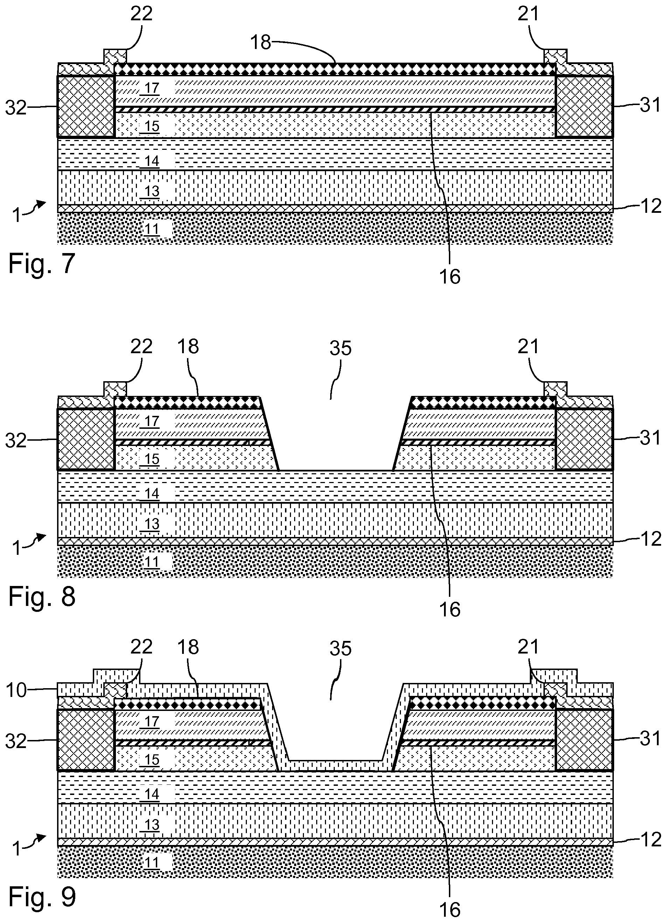

À la figure 7, on procède à la formation des cathodes 21 et 22 en contact ohmique avec les éléments semi-conducteurs 31 et 32 respectivement. Les cathodes 21 et 22 comportent ici de façon connue en soi un débordement sur la couche de passivation 18. Les cathodes 21 et 22 restent isolées électriquement par l'intermédiaire de la couche de passivation 18. La formation des cathodes 21 et 22 comprend par exemple une étape de dépôt métallique pleine plaque, suivie d'une étape de photolithographie, suivie d'une étape de gravure du motif des cathodes 21 et 22, suivie d'une étape de retrait du masque de photolithographie.

À la figure 8, on procède à la formation d'une tranchée 35 entre les cathodes 21 et 22, à distance des cathodes 21 et 22. La tranchée 35 est formée à travers les couches 18, 17 et 15 jusqu'à découvrir la couche 14. La formation de la tranchée 35 comprend par exemple une étape de photolithographie, suivie d'une gravure de la tranchée 35, suivie du retrait du masque de photolithographie. La tranchée 35 présente avantageusement des parois latérales inclinées par rapport à la verticale.

À la figure 9, on procède à la formation pleine plaque d'une couche 10 d'un matériau semi-conducteur de type III-N présentant un dopage de type P. La formation de la couche 10 est par exemple réalisée par croissance par épitaxie, par exemple par épitaxie d'un GaN dopé P. Du magnésium peut notamment être utilisé comme dopant de type P.

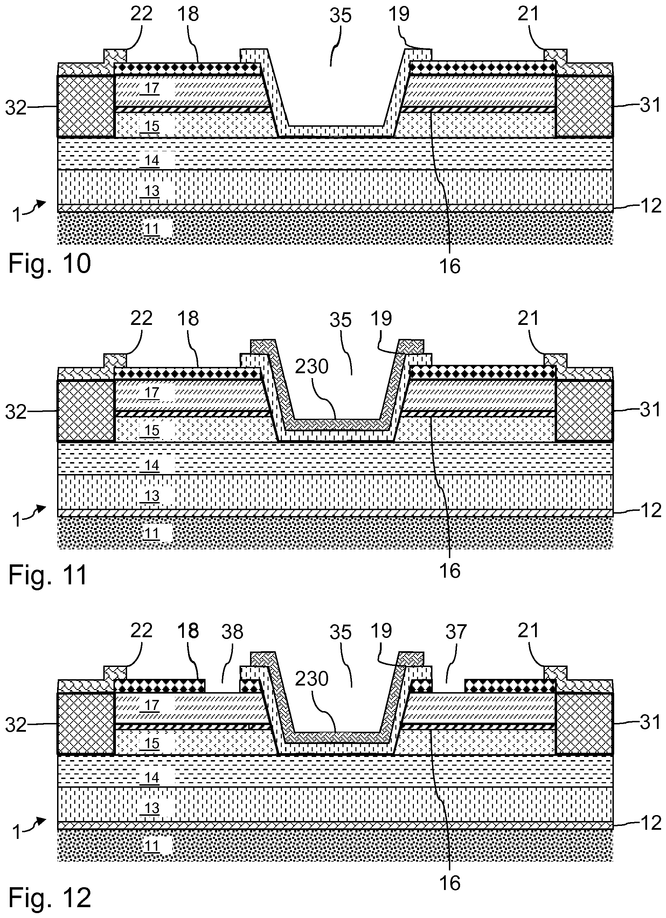

À la figure 10, on procède à la mise en forme de l'élément semi-conducteur 19 dopé P. La mise en forme de l'élément 19 peut par exemple comprendre une étape de photolithographie, suivie d'une gravure de l'élément 19, suivie du retrait du masque de photolithographie. Dans la configuration illustrée, l'élément 19 comporte des parties latérales surplombant des bordures respectives de la couche de passivation 18.

À la figure 11, on procède à la formation d'une partie centrale 230 de l'anode. À cet effet, on dépose une couche métallique configurée pour former un contact ohmique avec l'élément semi-conducteur 19. Ce dépôt est typiquement effectué pleine plaque, puis suivi d'une étape de photolithographie et de gravure pour définir la forme de la partie centrale 230. Le dépôt n'est ainsi conservé qu'au niveau de la tranchée 35 pour obtenir une partie centrale 230 recouvrant l'essentiel de l'élément 19, mais le dépôt est retiré ailleurs, notamment pour découvrir la couche 18.

À la figure 12, on procède à la formation des ouvertures 37 et 38 à travers la couche de passivation 18, jusqu'à découvrir la couche 17 à travers ces ouvertures 37 et 38. Les ouvertures 37 et 38 sont ménagées entre l'élément 19 et les cathodes 21 et 22 respectivement. Les ouvertures 37 et 38 sont ici accolées à l'élément 19. Une partie de la couche de passivation 18 est conservée sous les parties latérales de l'élément 19. La formation des ouvertures 37 et 38 comprend par exemple une étape de photolithographie, suivie d'une gravure de la couche de passivation 18 jusqu'à découvrir une portion de la couche 17, suivie d'un retrait du masque de photolithographie.

À la figure 13, on procède à la formation de parties saillantes 231 de l'anode 23. Les parties saillantes 231 sont ici formées monobloc avec un dépôt métallique recouvrant la partie centrale 230. Un contact électrique est ainsi formé entre les parties saillantes 231 et la partie centrale 230. Les parties saillantes 231 sont en saillie latéralement en direction des cathodes 21 et 22 respectivement. Les parties saillantes 231 comportent chacune un contact Schottky 232 en contact avec la couche 17 à travers les ouvertures 37 et 38. Les parties saillantes 231 comportent ici un débordement 233 au-delà des contacts Schottky 232, au-dessus de la couche de passivation 18. Une électrode de type MIS est ainsi formée par ce débordement 233 au-dessus de la couche de passivation 18. L'anode 23 reste bien entendu isolée des cathodes 21 et 22 par l'intermédiaire de la couche de passivation 18. Le choix du matériau pour former un contact Schottky 232 peut être réalisé comme détaillé précédemment.

La formation des parties saillantes 231 est par exemple réalisée par dépôt pleine plaque d'un métal formant un contact Schottky avec la couche 17, suivi d'une photolithographie et d'une gravure du dépôt métallique autour de l'anode 23, suivie du retrait du masque de photolithographie.

Par une variante de ce procédé de fabrication, on peut réaliser une couche de passivation 18 présentant une zone en escalier recouverte par un débordement 233 de la partie saillante 231 de l'anode 23, comme illustré à la figure 14.

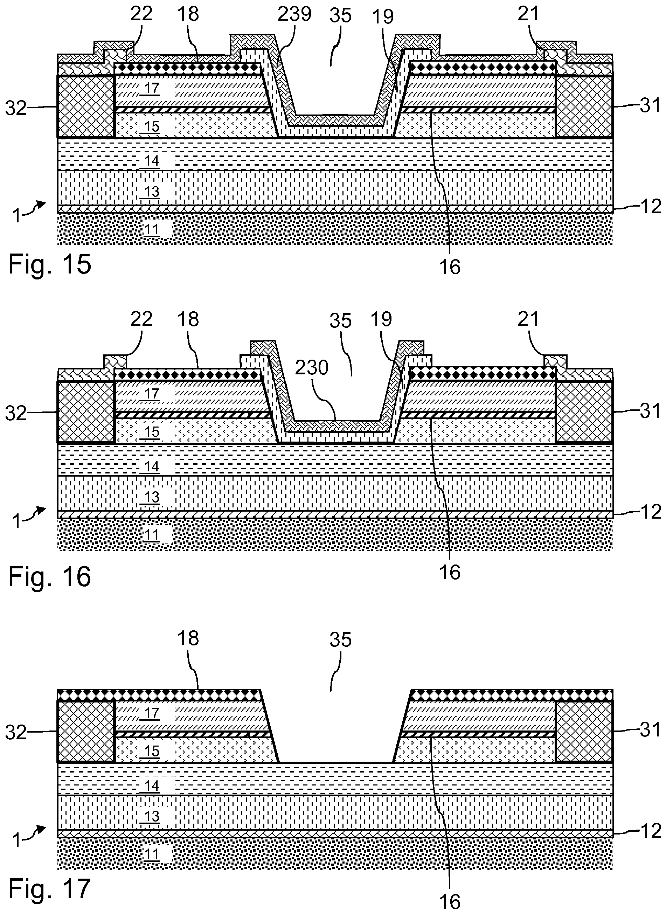

Les figures 15 et 16 illustrent une variante du procédé de fabrication décrit précédemment. Cette variante du procédé de fabrication est mise en œuvre à partir de l'étape illustrée à la figure 10. À l'issue de la figure 10, l'élément semi-conducteur 19 formé est en polysilicium ou en silicium amorphe. À la figure 15, on a procédé à un dépôt pleine plaque d'une couche 239 de Ni+TiN.

À la figure 16, on a procédé à un recuit sous N₂ de façon à faire réagir le Ni de la couche 239 avec le silicium de l'élément semi-conducteur 19. À l'aplomb de l'élément 19, on transforme la couche 239 en NiSi. Le reste de la couche 239 qui n'a pas réagi (et en particulier toute la partie de la couche 139 qui ne recouvre pas l'élément 19) a ensuite été retiré, par exemple par voie humide de façon sélective.

Avantageusement, la couche de passivation 18 peut inclure plusieurs couches superposées en matériaux différents, par exemple une superposition de couches de SiN/SiO₂. Par une attaque sélective, les différentes couches de la couche de passivation 18 peuvent être ouvertes successivement, pour former une forme en escalier telle que décrite précédemment. Une seule métallisation peut alors être réalisée pour former le contact 232 et des prolongements 233.

Le procédé décrit en référence aux figures 4 à 13 peut également être modifié comme suit. On peut ici reproduire les étapes mises en œuvre en référence aux figures 4 et 5. On procède ensuite à la formation d'une tranchée 35 entre les cathodes 21 et 22, à distance des cathodes 21 et 22, comme illustré à la figure 17. La tranchée 35 est formée à travers les couches 18, 17 et 15 jusqu'à découvrir la couche 14. La formation de la tranchée 35 comprend par exemple une étape de photolithographie, suivie d'une gravure de la tranchée 35, suivie du retrait du masque de photolithographie. La tranchée 35 présente avantageusement des parois latérales inclinées par rapport à la verticale.

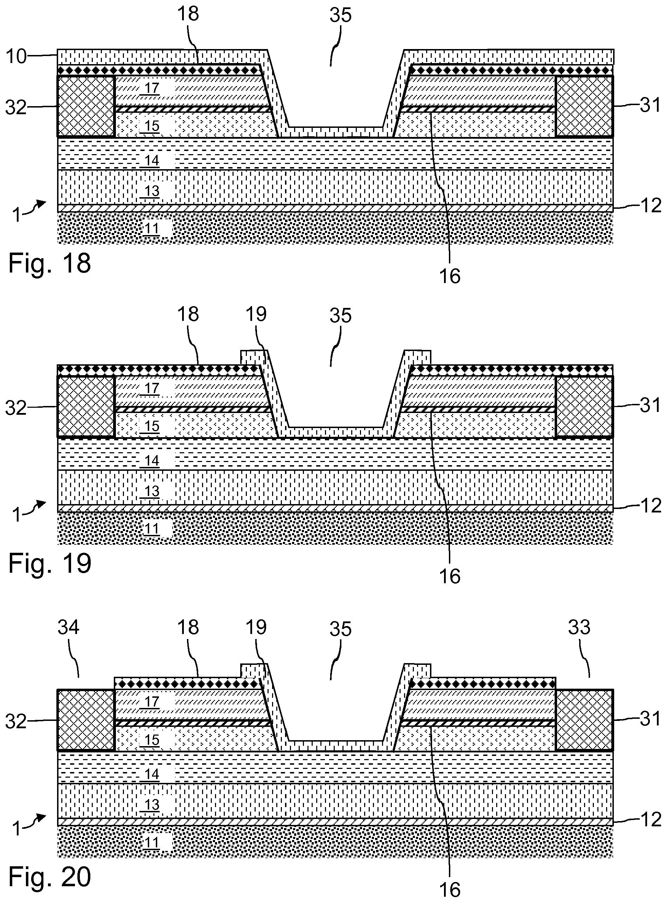

À la figure 18, on procède à la formation pleine plaque d'une couche 10 d'un matériau semi-conducteur de type III-N présentant un dopage de type P. La formation de la couche 10 est par exemple réalisée par croissance par épitaxie, par exemple par épitaxie d'un GaN dopé P. Du magnésium peut notamment être utilisé comme dopant de type P.

À la figure 19, on procède à la mise en forme de l'élément semi-conducteur 19 dopé P. La mise en forme de l'élément 19 peut par exemple comprendre une étape de photolithographie, suivie d'une gravure de l'élément 19, suivie du retrait du masque de photolithographie. Dans la configuration illustrée, l'élément 19 comporte des parties latérales surplombant des bordures respectives de la couche de passivation 18.

À la figure 20, on procède au retrait de la couche de passivation 18 à l'aplomb des éléments semi-conducteurs 31 et 32, de façon à ménager des zones dégagées 33 et 34 donnant accès aux faces supérieures des éléments semi-conducteurs 31 et 32 respectivement.

Pour former des cathodes 21 et 22 débordant sur la couche 17 comme détaillé précédemment, le retrait de la couche de passivation 18 peut dépasser latéralement les éléments semi-conducteurs 31 et 32. Les zones 33 et 34 sont par exemple formées par des étapes de photolithographie, puis de gravure de la couche de passivation 18 pour dégager l'accès aux faces supérieures des éléments semi-conducteurs 31 et 32, puis de retrait du masque de photolithographie.

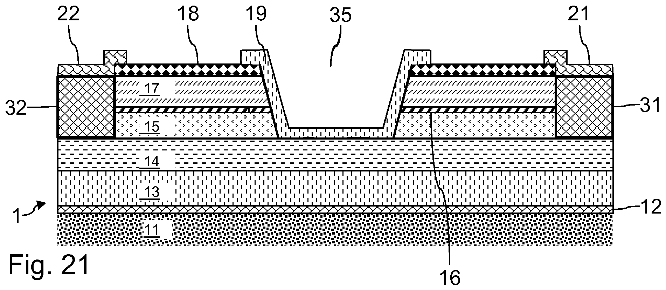

A la figure 21, on procède à la formation des cathodes 21 et 22 en contact ohmique avec les éléments semi-conducteurs 31 et 32 respectivement. Les cathodes 21 et 22 comportent ici de façon connue en soi un débordement sur la couche de passivation 18. Les cathodes 21 et 22 restent isolées électriquement par l'intermédiaire de la couche de passivation 18. La formation des cathodes 21 et 22 comprend par exemple une étape de dépôt métallique pleine plaque, suivie d'une étape de photolithographie, suivie d'une étape de gravure du motif des cathodes 21 et 22, suivie d'une étape de retrait du masque de photolithographie.

Le procédé peut être poursuivi comme décrit en référence aux figures 11 à 14.

Dans les exemples illustrés, les couches 15 et 17 sont directement en contact pour former une couche de gaz d'électrons 16 au niveau de leur interface. On peut également interposer de façon connue en soi une couche intermédiaire, par exemple une couche d'AlN lorsque la couche 15 est en GaN et que la couche 17 est en AlGaN. Une telle couche d'AlN présente typiquement une épaisseur de 1 nm.

## Revendications

1. Diode à hétérojonction (1), comprenant :
- des première et deuxième couches semiconductrices en matériau III-N (15, 17) superposées pour former une couche de gaz d'électrons (16), la première couche semi-conductrice étant en GaN;
- une anode (23) et une cathode (21), sélectivement connectées électriquement l'une à l'autre par l'intermédiaire de la couche de gaz d'électrons ;
- une troisième couche (14) semi-conductrice en GaN positionnée sous la couche de gaz d'électrons (16), présentant un dopage N, la première couche (15) semi-conductrice étant en contact avec la troisième couche semi-conductrice (14), lesdites première et troisième couches semi-conductrices (15, 14) étant formées d'un même alliage III-N avec des dopages différents, la première couche semi-conductrice étant de type non intentionnellement dopé ;
- un premier élément semi-conducteur (19) à dopage de type P, en contact avec l'anode (23), et formant une séparation entre l'anode et ladite troisième couche ;
- un deuxième élément semi-conducteur (31) à dopage de type N, en contact avec la cathode (21) et avec ladite troisième couche (14), et formant une séparation entre la cathode et ladite troisième couche ;
**caractérisée en ce que** :
- la troisième couche semi-conductrice en GaN présente une concentration du dopage N au plus égale à 4^{∗}10¹⁶cm⁻³;
- le premier élément semi-conducteur (19) est en contact avec la troisième couche semi-conductrice et la troisième couche semi conductrice et les premier et deuxième éléments semi-conducteurs (19, 31) forment une diode PIN.

2. Diode à hétérojonction (1), dans laquelle la concentration de dopants dans la troisième couche (14) est :
- inférieure à la concentration de dopants dans le premier élément semi-conducteur (19) ;
- inférieure à la concentration de dopants dans le deuxième élément semi-conducteur (31).

3. Diode à hétérojonction (1) selon la revendication 1 ou 2, dans laquelle ladite troisième couche (14) semi-conductrice est en GaN avec un dopage N présentant une concentration au moins égale à 5^{∗}10¹⁵cm⁻³.

4. Diode à hétérojonction (1) selon l'une quelconque des revendications précédentes, dans laquelle ledit premier élément semi-conducteur (19) est en GaN dopé P, en AlGaN dopé P, ou en Polysilicium dopé P.

5. Diode à hétérojonction (1) selon la revendication 4, dans laquelle la concentration de dopants P dans ledit premier élément semi-conducteur (19) est comprise entre 5^{∗}10¹⁷cm⁻³ et 10²⁰cm⁻³.

6. Diode à hétérojonction (1) selon l'une quelconque des revendications précédentes, dans laquelle ledit deuxième élément semi-conducteur (31) est en matériau GaN dopé N, en AlGaN dopé N, ou en Polysilicium dopé N.

7. Diode à hétérojonction (1) selon la revendication 6, dans laquelle la concentration de dopants N dans ledit deuxième élément semi-conducteur (31) est comprise entre 5^{∗}10¹⁷cm⁻³ et 10¹⁹cm⁻³.

8. Diode à hétérojonction (1) selon l'une quelconque des revendications précédentes, dans laquelle ladite deuxième couche (17) est en AlGaN.

9. Diode à hétérojonction (1) selon l'une quelconque des revendications précédentes, comportant une tranchée (35) traversant les première et deuxième couches semi-conductrices (15, 17) et dont le fond est délimité par ladite troisième couche semi-conductrice (14), ledit premier élément semi-conducteur (19) étant en contact avec ladite troisième couche semi-conductrice (14) dans le fond de ladite tranchée (35).

10. Diode à hétérojonction (1) selon l'une quelconque des revendications précédentes, dans laquelle l'anode (23) présente une partie saillante (231) latéralement par rapport audit premier élément semi-conducteur (19) en direction de ladite cathode, ladite partie saillante (231) étant en contact avec la deuxième couche (17) semi-conductrice.

11. Diode à hétérojonction (1) selon la revendication 10, dans laquelle la partie saillante (231) de l'anode (23) forme un contact Schottky avec ladite deuxième couche (17) semi-conductrice.

12. Diode à hétérojonction (1) selon la revendication 10, dans laquelle la partie saillante de l'anode (23) forme un contact ohmique ou Schottky (234) avec ladite deuxième couche (17) semi-conductrice, et présente un prolongement (235) au-delà du contact en direction de ladite cathode (21), un troisième élément semi-conducteur (191) dopé P étant positionné entre le contact (234) et la cathode (21), ce troisième élément semi-conducteur (191) étant surplombé par ledit prolongement (235) de l'anode et étant en contact avec la deuxième couche semi-conductrice (17).

13. Procédé de fabrication d'une diode à hétérojonction (1), comprenant les étapes de :
- fourniture de première et deuxième couches semiconductrices en matériau III-N (15, 17) superposées pour former une couche de gaz d'électrons (16), la première couche semi-conductrice (15) étant en GaN de type non intentionnellement dopé, d'une troisième couche (14) semi-conductrice en GaN positionnée sous la couche de gaz d'électrons (16) et présentant un dopage N, la première couche (15) semi-conductrice étant en contact avec la troisième couche semi-conductrice (14), lesdites première et troisième couches semi-conductrices (15, 14) étant formées d'un même alliage III-N avec des dopages différents ;
- formation d'un premier élément semi-conducteur (19) à dopage de type P;
- formation d'un deuxième élément semi-conducteur (31) à dopage de type N, en contact avec ladite troisième couche (14)
- formation d'une anode (23) sur le premier élément semi-conducteur (19), de façon à être séparée de ladite troisième couche (14) ;
- formation d'une cathode (21) sur ledit deuxième élément semi-conducteur (31), de façon à être séparée de ladite troisième couche (14) ;
le procédé étant **caractérisé en ce que**
- la troisième couche semi-conductrice en GaN présente une concentration du dopage N au plus égale à 4^{∗}10¹⁶cm⁻³ ;
- le premier élément semi-conducteur est en contact avec la troisième couche semi-conductrice et la troisième couche semi-conductrice et les premier et deuxième éléments semi-conducteurs forment une diode PIN.

## Patentansprüche

1. Heteroübergangsdiode (1), umfassend:
- erste und zweite Halbleiterschichten aus III-N-Material (15, 17), die übereinander gesetzt sind, um eine Elektronengasschicht (16) zu bilden, wobei die erste Halbleiterschicht aus GaN ist;
- eine Anode (23) und eine Kathode (21), die mittels der Elektronengasschicht selektiv elektrisch miteinander verbunden sind;
- eine dritte, unter der Elektronengasschicht (16) angeordnete Halbleiterschicht (14) aus GaN, die eine N-Dotierung aufweist, wobei die erste Halbleiterschicht (15) mit der dritten Halbleiterschicht (14) in Kontakt steht, wobei die erste und die dritte Halbleiterschicht (15, 14) aus der gleichen III-N-Legierung mit unterschiedlichen Dotierungen gebildet sind, wobei die erste Halbleiterschicht nicht absichtlich dotiert ist;
- ein erstes Halbleiterelement (19) mit P-Dotierung, das in Kontakt mit der Anode (23) steht und eine Trennung zwischen der Anode und der dritten Schicht bildet;
- ein zweites Halbleiterelement (31) mit N-Dotierung, das in Kontakt mit der Kathode (21) und mit der dritten Schicht (14) steht und eine Trennung zwischen der Kathode und der dritten Schicht bildet;
**dadurch gekennzeichnet, dass**:
- die dritte Halbleiterschicht aus GaN eine Konzentration der N-Dotierung von höchstens 4^{∗}10¹⁶cm⁻³ aufweist;
- das erste Halbleiterelement (19) in Kontakt mit der dritten Halbleiterschicht steht und die dritte Halbleiterschicht und das erste und das zweite Halbleiterelement (19, 31) eine PIN-Diode bilden.

2. Heteroübergangsdiode (1), bei der die Dotierungsstoffkonzentration in der dritten Schicht (14):
- geringer als die Dotierungsstoffkonzentration im ersten Halbleiterelement (19) ist;
- geringer ist als die Dotierungsstoffkonzentration im zweiten Halbleiterelement (31) ist.

3. Heteroübergangsdiode (1) nach Anspruch 1 oder 2, bei der die dritte Halbleiterschicht (14) aus GaN mit einer N-Dotierung ist, die eine Konzentration von mindestens 5^{∗}10¹⁵cm⁻³ aufweist.

4. Heteroübergangsdiode (1) nach einem der vorhergehenden Ansprüche, bei der das erste Halbleiterelement (19) aus P-dotiertem GaN, aus P-dotiertem AIGaN oder aus P-dotiertem Polysilicium ist.

5. Heteroübergangsdiode (1) nach Anspruch 4, bei der die Konzentration von P-Dotierungsstoffen im ersten Halbleiterelement (19) zwischen 5^{∗}10¹⁷cm⁻³ und 10²⁰cm⁻³ liegt.

6. Heteroübergangsdiode (1) nach einem der vorhergehenden Ansprüche, bei der das zweite Halbleiterelement (31) aus N-dotiertem GaN, aus N-dotiertem AIGaN oder aus N-dotiertem Polysilicium ist.

7. Heteroübergangsdiode (1) nach Anspruch 6, bei der die Konzentration von N-Dotierungsstoffen im zweiten Halbleiterelement (31) zwischen 5^{∗}10¹⁷cm⁻³ und 10¹⁹cm⁻³ liegt.

8. Heteroübergangsdiode (1) nach einem der vorhergehenden Ansprüche, bei der die zweite Schicht (17) aus AIGaN ist.

9. Heteroübergangsdiode (1) nach einem der vorhergehenden Ansprüche mit einem Graben (35), der die erste und die zweite Halbleiterschicht (15, 17) durchdringt und dessen Boden durch die dritte Halbleiterschicht (14) begrenzt wird, wobei das erste Halbleiterelement (19) mit der dritten Halbleiterschicht (14) im Boden des Grabens (35) in Kontakt steht.

10. Heteroübergangsdiode (1) nach einem der vorhergehenden Ansprüche, bei der die Anode (23) einen in Bezug auf das erste Halbleiterelement (19) seitlich in Richtung der Kathode vorspringenden Teil (231) aufweist, wobei der vorspringende Teil (231) mit der zweiten Halbleiterschicht (17) in Kontakt steht.

11. Heteroübergangsdiode (1) nach Anspruch 10, bei welcher der vorspringende Teil (231) der Anode (23) einen Schottky-Kontakt mit der zweiten Halbleiterschicht (17) bildet.

12. Heteroübergangsdiode (1) nach Anspruch 10, bei welcher der vorspringende Teil der Anode (23) einen ohmschen oder Schottky-Kontakt (234) mit der zweiten Halbleiterschicht (17) bildet und eine Verlängerung (235) über den Kontakt hinaus in Richtung der Kathode (21) aufweist, wobei ein drittes P-dotiertes Halbleiterelement (191) zwischen dem Kontakt (234) und der Kathode (21) angeordnet ist, wobei dieses dritte Halbleiterelement (191) von der Verlängerung (235) der Anode überragt wird und in Kontakt mit der zweiten Halbleiterschicht (17) steht.

13. Verfahren zur Herstellung einer Heteroübergangsdiode (1), umfassend die folgenden Schritte:
- Bereitstellen von ersten und zweiten Halbleiterschichten aus III-N-Material (15, 17), die übereinander gesetzt sind, um eine Elektronengasschicht (16) zu bilden, wobei die erste Halbleiterschicht (15) aus nicht absichtlich dotiertem GaN ist, einer dritten Halbleiterschicht (14) aus GaN, die unter der Elektronengasschicht (16) angeordnet ist und eine N-Dotierung aufweist, wobei die erste Halbleiterschicht (15) in Kontakt mit der dritten Halbleiterschicht (14) steht, wobei die erste und die dritte Halbleiterschicht (15, 14) aus der gleichen III-N-Legierung mit unterschiedlichen Dotierungen gebildet sind;
- Bilden eines ersten Halbleiterelements (19) mit P-Dotierung;
- Bilden eines zweiten Halbleiterelements (31) mit N-Dotierung, das in Kontakt mit der dritten Schicht steht;
- Bilden einer Anode (23) auf dem ersten Halbleiterelement (19) derart, dass sie von der dritten Schicht (14) getrennt ist;
- Bilden einer Kathode (21) auf dem zweiten Halbleiterelement (31) derart, dass sie von der dritten Schicht (14) getrennt ist;
wobei das Verfahren **dadurch gekennzeichnet ist, dass**:
- die dritte Halbleiterschicht aus GaN eine Konzentration der N-Dotierung von höchstens 4^{∗}10¹⁶cm⁻³ aufweist;
- das erste Halbleiterelement in Kontakt mit der dritten Halbleiterschicht steht und die dritte Halbleiterschicht und das erste und das zweite Halbleiterelement eine PIN-Diode bilden.

## Claims

1. Heterojunction diode (1) comprising:
- first and second semi-conductive layers (15, 17) made of III-N material that are superposed to form an electron gas layer (16), the first semi-conductive layer being made of GaN;
- an anode (23) and a cathode (21) selectively electrically connected to each other by means of the electron gas layer;
- a third semi-conductive layer (14) made of GaN, positioned under the electron gas layer (16), having an N-doping, the first semi-conductive layer (15) being in contact with the third semi-conductive layer (14), said first and third semi-conductive layers (15, 14) being formed from the same III-N alloy with different dopings, the first semi-conductive layer being of the unintentionally doped type;
- a first P-doped semi-conductor element (19) in contact with the anode (23) and forming a separation between the anode and said third layer;
- a second N-doped semi-conductor element (31) in contact with the cathode (21) and with said third layer (14) and forming a separation between the cathode and said third layer;
**characterized in that**:
- the third semi-conductive layer made of GaN has an N-doping concentration at most equal to 4^{∗}10¹⁶cm⁻³;
- the first semi-conductor element (19) is in contact with the third semi-conductive layer and the third semi-conductive layer and the first and second semi-conductor elements (19, 31) form a PIN diode.

2. Heterojunction diode (1), wherein the concentration of dopants in the third layer (14) is:
- less than the concentration of dopants in the first semi-conductor element (19);
- less than the concentration of dopants in the second semi-conductor element (31).

3. Heterojunction diode (1) according to Claim 1 or 2, wherein said third semi-conductive layer (14) is made of GaN with an N-doping having a concentration at least equal to 5^{∗}10¹⁵cm⁻³.

4. Heterojunction diode (1) according to anyone of the preceding claims, wherein said first semi-conductor element (19) is made of P-doped GaN, P-doped AIGaN or P-doped polysilicon.

5. Heterojunction diode (1) according to Claim 4, wherein the concentration of P-dopants in said first semi-conductor element (19) between 5^{∗}10¹⁷cm⁻³ and 10²⁰cm⁻³.

6. Heterojunction diode (1) according to anyone of the preceding claims, wherein said second semi-conductor element (31) is made of N-doped GaN, N-doped AIGaN or N-doped polysilicon.

7. Heterojunction diode (1) according to Claim 6, wherein the concentration of N-dopants in said second semi-conductor element (31) is between 5^{∗}10¹⁷cm⁻³ and 10¹⁹cm⁻³.

8. Heterojunction diode (1) according to any one of the preceding claims, wherein said second layer (17) is made of AIGaN.

9. Heterojunction diode (1) according to any one of the preceding claims, comprising a channel (35), which passes through the first and second semi-conductive layers (15, 17) and the bottom of which is delimited by said third semi-conductive layer (14), said first semi-conductor element (19) being in contact with said third semi-conductive layer (14) at the bottom of said channel (35).

10. Heterojunction diode (1) according to any one of the preceding claims, wherein the anode (23) has a portion (231) projecting laterally relative to said first semi-conductor element (19) toward said cathode, said projecting portion (231) being in contact with the second semi-conductive layer (17).

11. Heterojunction diode (1) according to Claim 10, wherein the projecting portion (231) of the anode (23) forms a Schottky contact with said second semi-conductive layer (17).

12. Heterojunction diode (1) according to Claim 10, wherein the projecting portion of the anode (23) forms an ohmic or Schottky contact (234) with said second semi-conductive layer (17) and has an extension (235) beyond the contact toward said cathode (21), a third P-doped semi-conductor element (191) being positioned between the contact (234) and the cathode (21), this third semi-conductor element (191) being overhung by said extension (235) of the anode and being in contact with the second semi-conductive layer (17).

13. Method for manufacturing a heterojunction diode (1), comprising the steps of:
- supplying first and second semi-conductive layers (15, 17) made of III-N material superposed to form an electron gas layer (16), the first semi-conductive layer (15) being made of GaN of the unintentionally doped type, a third semi-conductive layer (14) made of GaN positioned under the electron gas layer (16) and having an N-doping, the first semi-conductive layer (15) being in contact with the third semi-conductive layer (14), said first and third semi-conductive layers (15, 14) being formed from the same III-N alloy with different dopings;
- forming a first P-doped semi-conductor element (19);
- forming a second N-doped semi-conductor element (31) in contact with said third layer (14);
- forming an anode (23) on the first semi-conductor element (19), so as to be separated from said third layer (14);
- forming a cathode (21) on said second semi-conductor element (31), so as to be separated from said third layer (14);
the method being **characterized in that**:
- the third semi-conductive layer made of GaN has an N-doping concentration at most equal to 4^{∗}10¹⁶cm⁻³;
- the first semi-conductor element is in contact with the third semi-conductive layer and the third semi-conductive layer and the first and second semi-conductor elements form a PIN diode.
